# EUROPÄISCHE PATENTSCHRIFT

(11) **EP 3 600 894 B1**
(45) Veröffentlichungstag und Bekanntmachung des Hinweises auf die Patenterteilung: **12.05.2021**
(21) Anmeldenummer: 18712574.5
(22) Anmeldetag: 20.03.2018
(51) Int. Cl.: B41F 15/18, B41F 15/26, H01L 21/677

(54) **DRUCKVORRICHTUNG**
PRINTING APPARATUS
DISPOSITIF D'IMPRESSION

(30) Priorität: 20.03.2017 DE 102017204630
(43) Veröffentlichungstag der Anmeldung: 05.02.2020
(73) Patentinhaber: EKRA Automatisierungssysteme GmbH, 74357 Bönnigheim (DE)
(72) Erfinder: REINISCH, Hubert, 71691 Freiberg am Neckar (DE)
(74) Vertreter: Clarenbach, Carl-Philipp
(86) Internationale Anmeldenummer: PCT/EP2018/056930
(87) Internationale Veröffentlichungsnummer: WO 2018/172305

(56) Entgegenhaltungen:
- EP-A2- 2 138 305
- WO-A1-2009/141319

## Beschreibung

Die Erfindung betrifft eine Druckvorrichtung zum Bedrucken von Substraten, insbesondere Solarzellen, Wafer, Leiterplatten oder dergleichen, mit einer Druckeinrichtung, der zumindest ein bewegbarer Drucktisch zugeordnet ist, mit einer Förderbahn, entlang welcher die Substrate bewegbar sind, und mit einer Transporteinrichtung zum Transportieren der Substrate von der Förderbahn zu dem Drucktisch und zurück.

Druckvorrichtungen der eingangs genannten Art sind aus dem Stand der Technik bereits bekannt. Für die Handhabung flacher/flächiger Substrate, wie insbesondere Solarzellen, Wafer, Leiterplatten oder dergleichen, sind Druckvorrichtungen notwendig, welche die Substrate mit einer ausreichenden Sorgfalt und präzise für eine Bearbeitung bewegen können. Flache Substrate aus der Elektrotechnik werden häufig mit einer elektrisch leitfähigen Paste bedruckt, um beispielsweise elektrische Leiterbahnen und/oder elektrisch leitfähige Kontaktstellen herzustellen. Dazu sind Druckeinrichtungen bekannt, die beispielsweise mittels eines Rakels, das über ein Drucksieb oder eine Druckmaske geschoben wird, ein vorbestimmtes Muster von elektrischen Leiternbahnen auf den Substraten auftragen. Üblicherweise weist eine derartige Druckvorrichtung dabei einen Drucktisch auf, auf welchem das Substrat ablegbar ist. Dabei ist der Drucktisch bewegbar, um das Substrat beispielsweise von einer Aufnahmeposition in eine Druckposition gegenüber dem Rakel und/oder einer Druckmaske zu bringen. Um Substrate auf den Drucktisch zu bewegen und von diesem zu entfernen, ist üblicherweise eine Transporteinrichtung vorgesehen, die die Substrate beispielsweise mechanisch oder pneumatisch greift und transportiert. Zur Zuführung und Abführung der Substrate ist es bekannt, diese entlang einer Förderbahn zu transportieren oder zu fördern, entlang welcher eine oder mehrere derartiger Druckeinrichtungen oder anders gearteter Bearbeitungsvorrichtungen angeordnet sind. Die Transporteinrichtung entnimmt dann beispielsweise ein Substrat von der Förderbahn und führt es dem Drucktisch zu, um es nach erfolgtem Druckvorgang wieder zurück auf die Förderbahn zu bewegen. Das Transportieren der Substrate von der Förderbahn zu einer Druckeinrichtung und zurück bedarf einer aufwendigen Mechanik und Aktuatorik, um einen sicheren und schnellen Transport zu gewährleisten.

Aus der Offenlegungsschrift WO 2009/141319 A1 ist ein Siebdrucksystem mit einem Pendeltisch bekannt, der zwischen zwei Förderbahnen angeordnet ist und vier Drucknester trägt, von denen gleichzeitig jeweils zwei der Drucknester jeweils eine der Förderbahnen vervollständigen und die zwei verbleibenden Drucknester jeweils einer zwischen den Förderbahnen liegenden Druckeinrichtung zugeordnet sind.

Aus der Offenlegungsschrift EP 2 138 305 A2 ist weiterhin eine Druckvorrichtung mit einem Drehtisch bekannt, der vier Drucknester trägt und der zwischen einem Zuführförderband und einem Abführförderband angeordnet ist.

Der Erfindung liegt die Aufgabe zugrunde, eine verbesserte Druckvorrichtung zu schaffen, die einen einfachen, sicheren und schnellen Transport von Substraten von der Förderbahn zu einer Druckeinrichtung und zurück gewährleistet, ohne dass hierfür eine aufwendige Aktuatorik notwendig ist.

Die der Erfindung zugrundeliegende Aufgabe wird durch eine Druckvorrichtung mit den Merkmalen des Anspruchs 1 gelöst. Diese Druckvorrichtung hat den Vorteil, dass das jeweilige Substrat durch eine einfache Bewegung, die durch eine besonders einfache Kinematik erreicht wird, von der Förderbahn zu der Druckeinrichtung und zurück bewegbar ist. Dabei reicht zunächst ein Aktuator aus, um den Transport des Substrats zu ermöglichen. Erfindungsgemäß ist dabei vorgesehen, dass die Transporteinrichtung zumindest ein um eine Pendelachse verschwenkbares oder drehbares Transportpendel aufweist, das an zumindest einem von der Pendelachse beabstandeten Ende einen Drucktisch aufweist, wobei der Drucktisch durch das Transportpendel in eine erste, der Druckeinrichtung zugeordnete Position für einen Druckvorgang und in eine zweite in der Förderbahn liegende Position verschwenkbar ist, wobei der Drucktisch eine Fördereinrichtung aufweist, um die Förderbahn in der zweiten Position mit zu bilden. Der Transport von der zweiten Position in die erste Position beziehungsweise von der Förderbahn zu der Druckeinrichtung erfolgt somit durch eine Schwenkbewegung um die Pendelachse, sodass der Drucktisch entlang einer Kreisbahn bewegt wird. Weil die zweite Position in der Förderbahn liegt und das Transportpendel somit in der zweiten Position die Förderbahn mitbildet, wird ein Substrat einfach auf den Drucktisch durch die Förderbahn selbst transportiert, wobei die Fördereinrichtung des Drucktischs den Transport des jeweiligen Substrats auf den Drucktisch und von dem Drucktisch auf die Förderbahn vereinfacht. Durch die Fördereinrichtung wird außerdem erreicht, dass der Drucktisch die Förderbahn selbst mitbildet, sodass ein Substrat einfach über den Drucktisch in der zweiten Position hinweg gefördert werden kann, um beispielsweise an der Druckeinrichtung vorbei zu einer in der Fertigungslinie weiter hinten stehende Bearbeitungseinrichtung zu transportieren. Die Druckvorrichtung hat somit auch den Vorteil, dass eine Art Bypass für Substrate zur Verfügung gestellt ist, durch welchen die Substrate unkompliziert an der jeweiligen Druckeinrichtung vorbeigeführt werden können. Ein weiterer Vorteil, der sich aus der erfindungsgemäßen Ausführung der Druckvorrichtung ergibt, liegt darin, dass das Transportpendel schwenkend, beispielsweise um nur 180°, ausgeführt sein kann, sodass keine Drehdurchführung von Medien, wie Luft, Vakuum oder Strom, erforderlich ist, die zu dem Drucktisch geführt werden sollen. Dadurch ist eine einfache Mechanik und Verbindungstechnik nutzbar. Hierdurch ergeben sich Vorteile sowohl bezüglich der Kosten als auch bezüglich der Dauerfestigkeit der Druckvorrichtung.

Gemäß einer bevorzugten Weiterbildung der Erfindung ist vorgesehen, dass an zumindest zwei von der Pendelachse beabstandeten Enden des Transportpendels jeweils ein Drucktisch angeordnet ist, wodurch die Taktfrequenz beziehungsweise der Durchsatz der Druckvorrichtung erhöht wird. Damit trägt das Transportpendel zwei Drucktische, die von der ersten in die zweite Position durch das Verschwenken des Transportpendels die Pendelachse transportiert werden können. Dabei sind die Drucktische bevorzugt derart angeordnet, dass dann, wenn einer der Drucktische in der ersten Position liegt, der andere Drucktisch in der zweiten Position liegt.

Insbesondere sind die Drucktische zu der Pendelachse diametral einander gegenüberliegend angeordnet, um eine einfache Transportbewegung des Transportpendels zu ermöglichen, bei der stets dann, wenn einer der Drucktische in der ersten Position liegt, der andere in der zweiten Position angeordnet ist. Dadurch wird es beispielsweise möglich, dass ein auf einem der Drucktische aufliegendes Substrat bedruckt werden kann, während ein anderes Substrat über den in der Förderbahn liegenden Drucktisch hinweg gefördert wird. Damit wird während der Durchführung eines Druckvorgangs die Förderbahn nicht unterbrochen und das Weiterfördern von Substraten ist gewährleistet, sodass der Gesamtdurchsatz von Substraten durch die Druckvorrichtung in einfacher Art und Weise erhöht wird. Dabei wird aufgrund der vorteilhaften Integration der Transporteinrichtung in die Förderbahn außerdem eine bauraumsparende und konstruktiv einfache Lösung geboten.

Weiterhin ist bevorzugt vorgesehen, dass die jeweilige Fördereinrichtung ein antreibbares Förderband, insbesondere Vakuumband, Papierband oder dergleichen, aufweist, das eine Substratauflage für die Substrate auf dem jeweiligen Drucktisch bildet. Durch das Förderband sind die Substrate auf einfache Art und Weise über den Drucktisch mittels der Fördereinrichtung förderbar. Das jeweilige Förderband bildet dabei die Substratauflage für die Substrate auf dem Drucktisch. Dieser ist optional mit mehreren Saugöffnungen versehen, die insbesondere durch das Vakuumband oder ein luftdurchlässige Papierband eine Sogwirkung auf ein auf dem Förderband aufliegendes Substrat ausüben können, um dieses auf den Drucktisch insbesondere während des Druckvorgangs zu fixieren. Darüber hinaus kann durch die Vakuum-Fixierung auch sichergestellt werden, dass das Substrat beim Verschwenken des Transportpendels sicher auf dem Drucktisch verbleibt. Im Unterschied zum Papierband muss das Vakuumband selbst eigene Vakuum- oder Saugöffnungen aufweisen und ist ansonsten vorzugsweise aus einem luftundurchlässigen Material, insbesondere aus einem elastisch verformbaren Material, gefertigt, das eine definiert elastische Auflage für das jeweilige Substrat bietet, wobei die Elastizität der Auflage beispielsweise durch ihre Shore-Härte definiert und durch eine geeignete Materialauswahl einstellbar ist. Bevorzugt weist die jeweilige Fördereinrichtung entweder ein Förderband auf, das sich über zumindest im Wesentlichen den gesamten Drucktisch erstreckt, um eine großflächige Auflage für das jeweilige Substrat zu bieten, oder zumindest zwei oder mehr parallel zueinander ausgerichtete Förderbänder, auf welchen das Substrat auflegbar ist und die zusammen die Substratauflagen bilden.

Die jeweilige Fördereinrichtung weist bevorzugt eine austauschbare Förderbandkassette auf. Alternativ ist die Fördereinrichtung insgesamt als auswechselbare Einheit, beispielsweise in Form der Förderbandkassette mit optional integrierter Antriebseinrichtung, ausgebildet. Damit ist das Förderband in einfacher Art und Weise bei einer Wartung oder zur Reinigung austauschbar, indem die Förderbandkassette ausgetauscht wird. Hierdurch ist eine kostengünstige und schnelle Wartung und Instandhaltung der Druckvorrichtung gewährleistet.

Weiterhin sieht die Erfindung bevorzugt vor, dass die Förderbahn für jedes der Transportpendel einen unterbrochenen Abschnitt beziehungsweise eine Unterbrechung aufweist, wobei in der zweiten Position der jeweilige Drucktisch den unterbrochenen Abschnitt ausfüllt oder ersetzt, um die Förderbahn zu vervollständigen. Die Förderbahn weist somit für das jeweilige Transportpendel eine Unterbrechung auf, die durch einen der Drucktische vervollständigt werden kann, um die Förderbahn fortzusetzen. Der Drucktisch des Transportpendels vervollständigt somit in der zweiten Position die Förderbahn, sodass diese eine durchgehende Förderbahn bildet, entlang welcher Substrate an der einen Druckeinrichtung vorbei zu einer weiteren Bearbeitungsstation, insbesondere einer weiteren Druckeinrichtung, gefördert werden können. Weiterhin ist bevorzugt vorgesehen, dass die jeweilige Pendelachse vertikal ausgerichtet ist, sodass der jeweilige Drucktisch durch das Transportpendel in einer horizontalen Ebene bewegt, insbesondere verschwenkt wird. Dadurch ist das Transportpendel kostengünstig und konstruktiv einfach lagerbar. Durch das Verschwenken um die vertikale Achse benötigt das Transportpendel lediglich ausreichend Platz in der horizontalen Ebene, um eine Kollision mit anderen Bestandteilen der Druckvorrichtung zu vermeiden. Um die Förderbahn in der zweiten Position mit zu bilden, ist das Transportpendel beispielsweise derart verschwenkbar, dass der der Förderbahn zugeordnete Drucktisch auf der Förderbahn zu liegen kommt, und entlang der Förderbahn geförderte Substrate aufnimmt und selbst mittels der Fördereinrichtung weiter fördert. Dabei weist der Drucktisch dazu bevorzugt eine Aufnahmeschräge sowie eine Abfuhrschräge auf, die das Anheben und Aufnehmen der Substrate von der Förderbahn beziehungsweise das Ablegen der Substrate auf die Förderbahn erleichtern.

Gemäß einer bevorzugten Weiterbildung der Erfindung ist vorgesehen, dass zumindest die Substratauflage jedes Drucktischs vertikal verschiebbar ist. Dadurch wird erreicht, dass die jeweilige Substratauflage in der Höhe verstellbar beziehungsweise anhebbar oder absenkbar ist. Dadurch ist ein einfaches Führen der Substratauflage insbesondere in die Förderbahn oder in die Nähe der Druckmaske beziehungsweise Druckeinrichtung gewährleistet. Insbesondere ist dabei das Transportpendel derart ausgebildet, dass der Drucktisch zunächst unterhalb der Förderbahn durch das in der horizontalen Ebene verschwenkbare Transportpendel bewegt wird, und dass zum Vervollständigen der Transportbahn die Substratauflage von unterhalb der Förderbahn angehoben und in die Unterbrechung der Förderbahn eingeführt wird, um diese auszufüllen beziehungsweise zu ersetzen. Dadurch ist eine einfache Vervollständigung der Förderbahn durch den jeweiligen Drucktisch beziehungsweise das Transportpendel in der zweiten Position des Drucktischs gewährleistet. Um ein einfaches Einführen und Positionieren des Drucktischs in der ersten und/oder zweiten Position zu gewährleisten, ist optional insbesondere dem Drucktisch und/oder der Substratauflage eine Zentriervorrichtung, insbesondere Zentrierführung, an der Förderbahn zugeordnet.

Gemäß einer bevorzugten Weiterbildung der Erfindung ist vorgesehen, dass der ersten und/oder zweiten Position des jeweiligen Drucktischs und/oder an jedem Drucktisch der jeweiligen Substratauflage eine Hebeeinrichtung für die jeweilige Substratauflage zugeordnet ist. Ist die Hebeeinrichtung an dem jeweiligen Drucktisch angeordnet, um die dort befindliche Substratauflage bei Bedarf anzuheben oder absenken zu können, so ist ein weiterer Aktuator mit dem Drucktisch mitzuführen, welcher das Anheben und Absenken der Substratauflage gewährleistet. Zwar ist dadurch ein individueller Betrieb der Substratauflagen in Bezug auf das Anheben gewährleistet, jedoch wird dafür entsprechender Bauraum auf dem jeweiligen Drucktisch für die jeweilige Hebeeinrichtung benötigt. Ist die jeweilige Hebeeinrichtung lediglich der ersten oder zweiten Position des jeweiligen Drucktischs zugeordnet, also als ortsfeste Hebeeinrichtung einer Druckvorrichtung, so ist der jeweilige Drucktisch bauraumsparend ausführbar und das Transportpendel mit wenig Eigenmasse realisierbar. Die ortsfesten Hebeeinrichtungen sind insbesondere dazu ausgebildet, die Substratauflage eines der ersten oder zweiten Position liegenden Drucktischs anzuheben. Dazu weist die Hebeeinrichtung beispielsweise einen oder mehrere Stempel, Stößel oder dergleichen auf, die entweder an dem jeweiligen Drucktisch vorbei oder durch eine Öffnung des jeweiligen Drucktischs hindurchführbar sind, um die auf dem Drucktisch angeordnete Substratauflage und/oder Substrate anzuheben. Dazu kann beispielsweise die Hebeeinrichtung mittels des Stößels oder Stempels mit der Fördereinrichtung zusammenwirken, um das Förderband insgesamt anzuheben oder abzusenken. Hierdurch ist eine einfache und kostengünstige Hebeeinrichtung realisiert. Alternativ ist die jeweilige Hebeeinrichtung dazu ausgebildet, den jeweiligen Drucktisch insgesamt oder das gesamte Transportpendel anzuheben, um dadurch die Substratauflage mitanzuheben. Dazu ist die jeweilige Hebeeinrichtung beispielsweise der ersten oder zweiten Position derart zugeordnet, dass sie dazu in der Lage ist, den jeweiligen Drucktisch bei Bedarf anzuheben oder abzusenken, also in der Höhe (z-Richtung) zu verstellen. Um ein sicheres Zusammenwirken von ortsfester Hebeeinrichtung und beweglichem Drucktisch zu gewährleisten, ist insbesondere vorgesehen, dass der Hebeeinrichtung Zentriermittel zugeordnet sind, welche ein sicheres Zuführen des Stößels und/oder Stempels zu der Substratauflage in der ersten oder zweiten Position des Drucktischs zu gewährleisten. Gemäß einer weiteren Ausführungsform der Erfindung ist bevorzugt vorgesehen, dass die jeweilige Hebeeinrichtung mit dem Transportpendel mitbewegt wird.

Gemäß einer alternativen Weiterbildung der Erfindung ist vorgesehen, dass jeweils das gesamte Transportpendel durch die Hebeeinrichtung anhebbar und absenkbar beziehungsweise in der Höhe verstellbar ist, um die zuvor beschriebene Anordnung der Drucktische und Zuführung zur Druckeinrichtung beziehungsweise Förderbahn zu gewährleisten. Dadurch wird die Anzahl der Hebeeinrichtungen für das jeweilige Transportpendel auf eine reduziert.

Insbesondere ist die jeweilige Hebeeinrichtung also dazu ausgebildet, ein Substrat von einer Transportposition in eine Druckposition an der Druckeinrichtung oder in eine Förderposition an der Förderbahn anzuheben. Hierdurch ergeben sich die zuvor bereits genannten Vorteile.

Weiterhin ist erfindungsgemäß vorgesehen, dass die Transporteinrichtung wenigstens ein weiteres Transportpendel aufweist, das wie das eine Transportpendel ausgebildet und neben dem einen Transportpendel angeordnet ist. Damit weist die Druckvorrichtung zumindest zwei Transportpendel auf, die nebeneinander angeordnet sind. Dabei weist die Förderbahn entsprechend der Anzahl der Transportpendel Unterbrechungen auf, sodass jedem Transportpendel eine zweite Position in oder an der Förderbahn zugeordnet ist, in welcher ein Drucktisch des jeweiligen Transportpendels anordenbar ist, um die Förderbahn mit zu bilden, wie zuvor bereits beschrieben.

Erfindungsgemäß sind die Transportpendel derart nah zueinander angeordnet, dass sich die Bewegungsbahnen ihrer Drucktische überschneiden. Hierdurch wird die Druckvorrichtung besonders bauraumsparend gestaltet. Zweckmäßigerweise werden die Transportpendel derart angetrieben, dass sie im Betrieb nicht miteinander kollidieren. Hierdurch ergibt sich ein Betrieb der Transportpendel, der beispielsweise dem eines Roots-Gebläses ähnelt. Es wird daher auch davon gesprochen, dass die Transportpendel in einer Roots-Anordnung ausgebildet sind.

Die Transportpendel sind erfindungsgemäß mechanisch oder elektrisch miteinander gekoppelt, um insbesondere den oben beschriebenen Antrieb zu realisieren. Durch die mechanische Kopplung ist eine Kollision benachbarter Transportpendel verlässlich und dauerhaft vermeidbar. Darüber hinaus kann auf einen weiteren Antrieb für das weitere Transportpendel verzichtet werden. Hierdurch ergibt sich eine kompakte und energiesparende Ausführungsform der Druckvorrichtung. Durch die elektrische Kopplung werden die den Transportpendeln zugeordneten Aktuatoren unabhängig voneinander angesteuert, um das Verschwenken des jeweiligen Transportpendels zu erreichen. Die elektrische Kopplung erlaubt einen individuellen Transportpendelantrieb, der es beispielsweise auch erlaubt, das die Transportpendel zumindest zeitweise parallel zueinander ausgerichtet sind. Damit ergeben sich weitere Freiheiten beim Betrieb der Druckvorrichtung. Optional werden die Fördereinrichtungen der Drucktische, insbesondere eines Transportpendels, gemeinsam angetrieben. Weiterhin ist bevorzugt vorgesehen, dass die Transporttische in ihrer ersten Position einer gemeinsamen Druckeinrichtung oder jeweils einer eigenen Druckeinrichtung zugeordnet sind. Damit können die beiden Transportpendel mit einer einzigen Druckeinrichtung zusammenwirken oder mit zwei unterschiedlichen oder zumindest separat ausgebildeten Druckeinrichtungen, die insbesondere unabhängig voneinander betrieben werden können. Je nach Prozessforderungen können Kombinationen von gemeinsamer Siebverstellungsmechanik, gemeinsamer Rakel- und/oder Flutbewegungsachse oder Mehrfachsiebe gebildet werden. Ebenso können einzelne Elemente auch doppelt vorgesehen werden, das heißt nicht gemeinsam, sondern getrennt ausgebildet.

Gemäß einer weiteren Ausführungsform der Erfindung ist bevorzugt vorgesehen, dass die Pendelachse horizontal ausgerichtet ist, sodass der jeweilige Drucktisch durch das

Transportpendel in einer vertikalen Ebene verschwenkt oder verdreht wird. Damit wird durch das Transportpendel ein Drucktisch angehoben und entlang einer Kreisbahn zu der Druckeinrichtung oder der Förderbahn geführt. Hierdurch kann Bauraum insbesondere in Richtung der Förderbahn gespart werden, jedoch wird sicher Bauraum in der vertikalen Ebene der Transportpendelbewegung gefordert.

Im Folgenden soll die Erfindung anhand der Zeichnung näher erläutert werden. Dazu zeigen
- Figur 1: eine vorteilhafte Druckvorrichtung in einer Seitenansicht,
- Figur 2: die Druckvorrichtung in einer Draufsicht,
- Figur 3: eine Detaildarstellung der Druckvorrichtung und
- Figuren 4A und 4B: die Druckvorrichtung in unterschiedlichen Betriebszuständen zur Erläuterung ihrer Funktion.

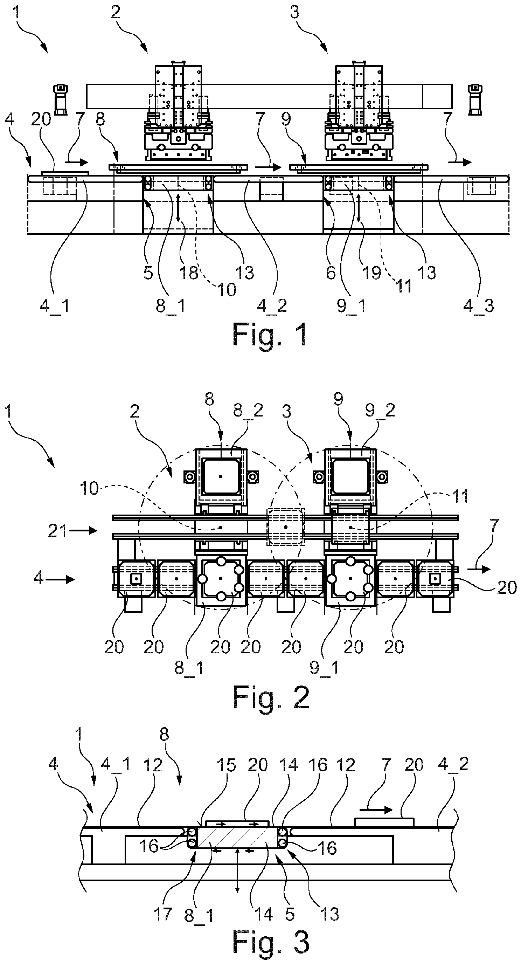

Figur 1 zeigt in einer vereinfachten Seitenansicht eine Druckvorrichtung 1, die dazu ausgebildet ist, Substrate, wie beispielsweise Solarzellen, Wafer, Leiterplatten oder dergleichen, mit einer insbesondere elektrisch leitfähigen Druckpaste zu bedrucken. Die Druckvorrichtung 1 weist zwei nebeneinander angeordnete Druckeinrichtungen 2 und 3 auf. Den Druckeinrichtungen 2, 3 ist eine Förderbahn 4 zugeordnet, entlang welcher Substrate zu den Druckeinrichtungen 2, 3 oder an diesen vorbei geführt werden können. Dazu weist die Förderbahn 4 mehrere in Reihe hintereinanderliegende Förderbahnabschnitte 4_1, 4_2 und 4_3 auf, wobei zwischen den Förderbahnabschnitten 4_1 und 4_2 eine erste Unterbrechung 5 und zwischen den Förderbahnabschnitten 4_2 und 4_3 eine zweite Unterbrechung 6 ausgebildet ist.

Figur 2 zeigt die Druckvorrichtung 1 in einer vereinfachten Draufsicht. Dabei ist zu erkennen, dass die Förderbahn 4 seitlich beabstandet zu den Druckeinrichtungen 2 und 3 angeordnet ist und an diesen vorbeiführt. Der Bewegungsweg der Substrate entlang der Förderbahn 4 ist dabei durch Pfeile 7 in Figur 2 und Figur 1 gezeigt. Jeder Druckeinrichtung 2, 3 ist darüber hinaus ein Transportpendel 8, 9 zugeordnet, das um eine vertikale Pendelachse 10 beziehungsweise 11 verschwenkbar ist. Das jeweilige Transportpendel 8, 9 weist dabei jeweils beabstandet zu der zugeordneten Pendelachse 10, 11 zwei diametral einander gegenüberliegende Drucktische 8_1, 8_2 beziehungsweise 9_1 und 9_2 auf. Die Drucktische 8_1, 8_2 und 9_1, 9_2 sind jeweils gleich beabstandet zu der zugehörigen Drehachse beziehungsweise Pendelachse 10, 11 angeordnet. In der in Figur 2 gezeigten Stellung sind die beiden Transportpendel 8, 9 derart ausgerichtet, dass sie parallel zueinander angeordnet sind. Dabei ist jeweils einer der Drucktische 8_1 und 9_1 der Förderbahn 4 und der jeweils andere Drucktisch 8_2, 9_2 des jeweiligen Transportpendels 8, 9 einer der Druckeinrichtungen 2, 3 zugeordnet. Die Transportpendel 8, 9 bilden eine Transporteinrichtung, mit deren Hilfe Substrate von der Förderbahn zu den Druckeinrichtungen 2, 3 und zurück transportiert werden können.

Parallel zu der Förderbahn 4 verläuft eine weitere Förderbahn 21, die als Durchlauf-Förderbahn ausgebildet ist, und insofern Substrate an der Druckvorrichtung 1 beziehungsweise den Druckeinrichtungen 2, 3 vorbei fördert, sodass diese keinen Prozessschritt an diesen Substraten vornimmt/vornehmen. Substrate, die sich auf der Förderbahn 21 befinden, werden beispielsweise mit einer analog zur Druckvorrichtung 1 ausgebildeten Druckvorrichtung bearbeitet, die in der Förderrichtung der Förderbahn 21 vor oder hinter der Druckvorrichtung 1 angeordnet ist. Dabei kann die weitere Druckvorrichtung wie die Druckvorrichtung 1 verwendet/betrieben werden, sodass sie beispielsweise Transportpendel aufweist, die die gleichen Maße wie die der Druckvorrichtung 1 aufweisen. Alternativ kann die weitere Druckvorrichtung aber auch mit kürzeren oder längeren Transportpendeln ausgebildet sein, also mit größerem oder kleinerem Radius, je nachdem, ob die Druckeinrichtungen der weiteren Druckeinrichtung näher oder weiter weg zu der Förderbahn 21 liegen als die Druckeinrichtungen 2, 3 zu der Förderbahn 4.

Die jeweilige Unterbrechung 5, 9 in der Förderbahn 4 entspricht dabei zumindest im Wesentlichen der Breite eines der Drucktische 8_1 bis 9 2. Weil die Drucktische 8_1 bis 9_2 jeweils gleich ausgebildet sind, wird im Folgenden der Einfachheit halber auf den oder die Drucktische Bezug genommen.

Die Pendelachsen 10, 11 sind dabei derart beabstandet zu der Förderbahn 4 angeordnet, dass in der gezeigten parallelen Ausrichtung der Transportpendel 8, 9 jeweils einer der Drucktische 8_1, 9_1 genau in der jeweiligen Unterbrechung 5, 6 der Förderbahn 4 angeordnet ist und dadurch die Förderbahn 4 vervollständigt.

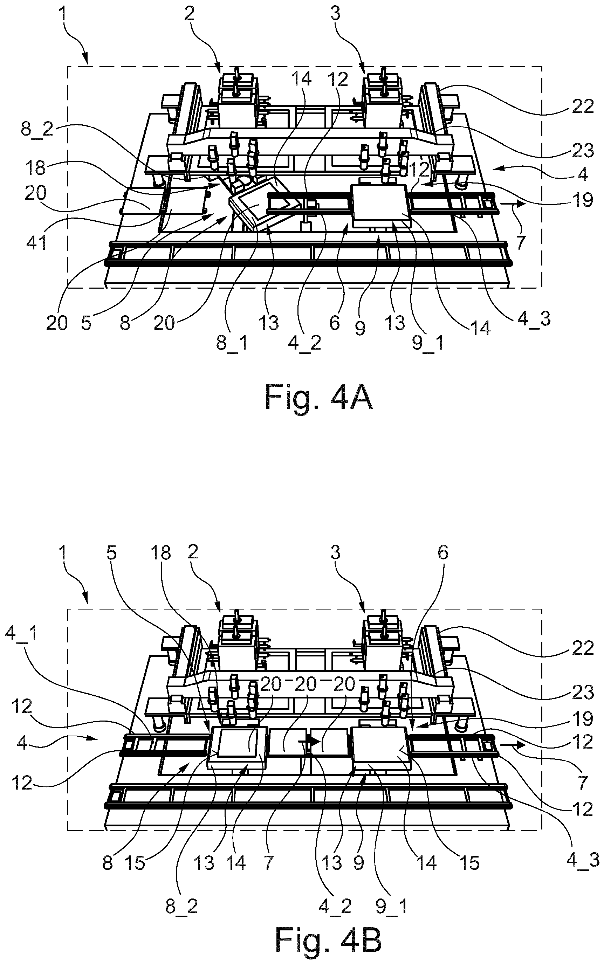

Figur 3 zeigt dazu in einer Detailseitenansicht den Drucktisch 8_1 des Transportpendels 8 im Bereich der Förderbahn 4. Wie bereits erläutert weist die Förderbahn 4 Fördermittel zum Transportieren der Substrate auf. Insbesondere weist die Förderbahn 4 dazu im jeweiligen Förderbahnabschnitt 4_1, 4_2, 4_3 zumindest ein Förderband 12 auf, mittels dessen das jeweilige Substrat transportiert werden kann. Vorteilhafterweise weist die Förderbahn 4 in jedem Förderbahnabschnitt zumindest zwei parallel zueinander ausgerichtete und beabstandet zueinander angeordnete Förderbänder 12 auf, wie beispielsweise auch in Figuren 4A und 4B ersichtlich. Die Förderbänder 12 beziehungsweise Förderbandabschnitte 4_1 bis 4_3 bilden zusammen eine Förderebene, entlang welcher die Substrate förderbar sind. Die Drucktische sind dazu ausgebildet, diese Förderebene der Förderbahn 4 zu vervollständigen, wenn sich der Drucktisch in der jeweiligen Unterbrechung 5 oder 6 der Förderbahn befindet. Die Förderbänder 12 können wie vorliegend als Flachriemen oder auch als Rundriemen ausgebildet oder mittels anderer Förderelemente, wie beispielsweise Förderrollen oder dergleichen, aufgebaut sein.

In Figur 3 ist dazu gezeigt, wie der Drucktisch 8_1 sich in der Unterbrechung 5 der Förderbahn 4 zwischen den Förderbahnabschnitten 4_1 und 4_2 befindet. Der jeweilige Drucktisch 8_1 - 9_2 weist selbst eine Fördereinrichtung 13 auf, mittels welcher die Substrate entlang der Förderbahn 4 weiter gefördert werden können, die Förderbahn 4 also vervollständigt wird. Die jeweilige Fördereinrichtung 13 weist dazu zweckmäßigerweise jeweils zumindest ein antreibbares Förderband 14 auf, sowie einen Aktuator, mittels dessen das Förderband 14 antreibbar ist. Bei dem Aktuator handelt es sich insbesondere um einen Elektromotor, der beispielsweise drehzahlgeregelt oder gesteuert das Förderband 14 bewegt. Das Förderband 14 ist dabei parallel beziehungsweise fluchtend zu den Förderbändern 12 der Förderbahnabschnitte 4_1 bis 4_3 ausgerichtet, sodass die Substrate entlang der Förderbahn 4 unterbrechungsfrei entlanggefördert werden können.

Das Förderband 14 des jeweiligen Drucktischs bildet dabei auch an der Oberseite des Drucktischs 8_1 eine Substratauflage 14, auf welcher die Substrate zum Liegen kommen. Der Drucktisch 8_1 ist in der in Figur 3 gezeigten Position derart in der Unterbrechung 5 der Förderbahn 4 angeordnet, dass die Substratauflage 15 bündig mit den Förderbändern 12 abschließt, sodass die Substrate auch im Bereich des Drucktischs auf Höhe der Förderebene, wie sie zuvor beschrieben wurde, entlanggefördert werden. Dadurch ist ein sicherer Transport der Substrate entlang der Förderbahn 4 gewährleistet, indem in jeder der Unterbrechungen 5, 6 jeweils einer der Drucktische liegt. Für den Transport des jeweiligen Förderbands 14 weist der jeweilige Drucktisch beziehungsweise die jeweilige Fördereinrichtung 13 zweckmäßigerweise mehrere Umlenkrollen 16 auf, sodass das Förderband 14 als Endlosmittel verwendbar ist.

Gemäß einer optionalen, vorteilhaften Ausführungsform ist vorgesehen, dass das Förderband 14 als Bestandteil einer Förderbandkassette 17 vorgesehen ist, die austauschbar an dem jeweiligen Drucktisch anordenbar und mit dem an dem Drucktisch vorgesehenen Aktuator beziehungsweise Antrieb in Wirkverbindung bringbar ist. Dadurch ist ein einfacher Austausch des Förderbands 14, beispielsweise zu Wartungszwecken, möglich. Dies ist insbesondere dann von Vorteil, wenn es sich bei dem Förderband um ein Papierband handelt, das schneller Verschleißerscheinungen aufweisen kann, als beispielsweise ein Kunststoffband. Die Förderbandkassette 17 ist beispielsweise radial zur Pendelachse 10 beziehungsweise 11 von dem jeweiligen Drucktisch abziehbar, um einen einfachen Austausch zu gewährleisten.

Optional ist vorgesehen, dass das verwendete Förderband 14 als Vakuumband ausgebildet ist, sodass es beispielsweise derart luftdurchlässig ist oder luftdurchlässige Öffnungen aufweist, dass durch einen im jeweiligen Drucktisch erzeugten Unterdruck ein Substrat an der Substratauflage 15 ansaugbar und dadurch per Vakuum an dieser arretierbar ist. Dies ist insbesondere dann von Vorteil, wenn das jeweilige Transportpendel 8 und/oder 9 mit auf den Drucktischen aufliegenden Substraten um die jeweilige Pendelachse 10, 11 verschwenkt wird, wie im Folgenden näher erörtert.

Damit der jeweilige Drucktisch in die jeweilige Unterbrechung 5, 6 der Förderbahn 4 einführbar ist, ist das jeweilige Transportpendel 8, 9 insgesamt in seiner Höhe (z-Richtung) verstellbar. Dazu ist dem jeweiligen Transportpendel 8, 9 jeweils eine Hebeeinrichtung 18, 19 zugeordnet, mittels derer das gesamte Transportpendel 8, 9 absenkbar und anhebbar ist. Alternativ sind die Drucktische 8_1 bis 9_2 individuell in der Höhe verstellbar beziehungsweise anhebbar und absenkbar. Dann ist insbesondere dem jeweiligen Drucktisch 8_1 bis 9_2 jeweils eine eigene Hebeeinrichtung zugeordnet. Die Hebeeinrichtungen können dabei mit dem Transportpendel mitgeführt werden oder stationär an der Förderbahn 4 und der jeweiligen Druckeinrichtung 2, 3 angeordnet sein, um die Drucktische oder die Substratauflagen 15 bei Bedarf anzuheben oder abzusenken.

Wie insbesondere Figur 2 entnehmbar, sind die Transportpendel 8, 9 gleich ausgebildet und weisen somit aufgrund ihrer drehbaren Anordnung an der jeweiligen Pendelachse 10, 11 eine kreisförmige Bewegungsbahn auf, deren maximaler Radius in Figur 2 durch jeweils eine Punkt-Strich-Linie gezeigt ist. Dabei ist ersichtlich, dass die Transportpendel 8, 9 derart zueinander angeordnet sind, dass sich die Bewegungsbereiche/Bewegungsbahnen überschneiden. Insbesondere ist dabei vorgesehen, dass die Transportpendel 8, 9 derart nahe aneinander angeordnet sind, dass dann, wenn beide zunächst parallel zueinander ausgerichtete Pendel um 90° verdreht werden würden, die Transportpendel 8, 9 miteinander kollidieren würden.

Diese Anordnung gewährleistet gleichzeitig außerdem, dass die Transportpendel 8, 9 derart weit voneinander angeordnet sind, dass dann, wenn nur eines der Transportpendel 8, 9 gedreht wird, eine Kollision sicher vermieden ist. Vorteilhafterweise sind die Transportpendel 8, 9 mechanisch und/oder elektrisch miteinander gekoppelt, sodass eine Kollision der Transportpendel 8, 9 sicher verhindert wird. Dazu werden die Transportpendel 8, 9 in der Art eines Roots-Getriebes beziehungsweise -Gebläses bewegt, wodurch ein sicherer Betrieb dauerhaft gewährleistet ist. Insbesondere kann ein derartiger Betrieb auch einfach durch mechanische oder elektrische Mittel realisiert sein, welche die Transportpendel 8, 9 miteinander koppeln.

Wie eingangs bereits erwähnt, sind die Transportpendel 8, 9 derart ausgebildet, dass dann, wenn einer der Drucktische in der Förderbahn 4 liegt, der andere der Drucktische der jeweiligen Druckeinrichtung 2 oder 3 zugeordnet ist. Im Ausführungsbeispiel von Figur 3 sind beispielsweise die Drucktische 8_2 und 9_2 der jeweiligen Druckeinrichtung 2 beziehungsweise 3 zugeordnet. Die jeweilige Druckeinrichtung 2, 3 weist dabei eine Druckmaske auf, sowie beispielsweise ein Rakel, mittels dessen die Druckpaste durch die Druckmaske hindurch auf das Substrat aufgetragen werden kann. Die Druckmasken sind dabei derart angeordnet, dass sie in einer für den Druckvorgang vorteilhaften Höhe bezüglich des jeweiligen Substrats liegen, wie es in Figur 3 gezeigt ist. Dies kann so ausgeführt sein, dass der unter der Druckmaske befindliche Drucktisch in ausgehobener Stellung ist. Entweder durch lokales Anheben des Drucktischs lokal unter der Druckmaske oder durch Anheben des gesamten Transportpendels 8, 9, wie zuvor bereits beschrieben. Ebenso ist es möglich, dass in der Druckposition kein Anheben des jeweiligen Drucktischs nötig ist, da ohnehin ein Abstand zwischen Druckmaske und Substratoberfläche angestrebt wird, sodass es ausreicht, an der Druckposition den Drucktisch nur horizontal einzuschwenken.

Weiter ist gewährleistet, dass während an der jeweiligen Druckeinrichtung 2, 3 ein Druckvorgang durchgeführt werden kann, gleichzeitig an der Förderbahn 4 ein Substrat an beiden Druckeinrichtungen vorbei mit Hilfe der Drucktische 8_1 und 8_2 vorbeigefördert werden kann. Damit wird die Förderbahn während der Durchführung eines Druckvorgangs nicht unterbrochen, sondern vielmehr durch das jeweilige Transportpendel 8, 9 vervollständigt.

Figuren 4A und 4B zeigen jeweils in einer perspektivischen Darstellung die Druckvorrichtung 1 in unterschiedlichen Funktionszuständen, um den Betrieb der Druckvorrichtung 1 zu erläutern. Ausgehend von den in Figur 3 gezeigten Position des Drucktisches 8_1 wird der Betrieb näher erläutert. Zunächst wird ein Substrat 20 mittels der Förderbahn 4 zu der ersten Unterbrechung 5 gefördert, in welcher der Drucktisch 8_1 liegt. Die Fördereinrichtung 13 des Drucktischs 8_1 wird angetrieben, um das Substrat 20 aufzunehmen und insbesondere mittig auf dem Drucktisch 8_1 zu platzieren, wie in Figur 3 gezeigt. Anschließend wird die Hebeeinrichtung 18 dazu angesteuert, den Drucktisch 8_1 beziehungsweise das Transportpendel 8 abzusenken, sodass die Substratauflage 15 zusammen mit dem Substrat 20 unterhalb der Förderbahn 4 liegt.

Anschließend wird das Transportpendel 8 durch ein Aktuator, insbesondere Elektromotor, in eine Drehbewegung versetzt, sodass der Drucktisch 8_1 unter der Förderbahn 4 weggedreht und der Druckeinrichtung 2 zugeführt wird. Gleichzeitig wird der zunächst der Druckeinrichtung 2 zugeordnete Drucktisch 8_2 von der Druckeinrichtung 2 in Richtung der Förderbahn 4 bewegt. Sobald das Transportpendel 8 um 180° geschwenkt wurde, wird die Hebeeinrichtung 18 erneut angesteuert, um das Transportpendel 8 oder nur den jeweiligen Drucktisch anzuheben, sodass nunmehr der Drucktisch 8_2 die Förderbahn 4 vervollständigt und der Drucktisch 8_1 zum Durchführen eines Druckvorgangs der Druckeinrichtung 2 zugeordnet ist, wie in Figur 4B gezeigt. Entsprechend wird auch das Transportpendel 9 betrieben. Während ein Druckvorgang in der Druckeinrichtung 2 durchgeführt wird, fördert das Transportpendel 8 mittels dem nunmehr Förderband 4 zugeordneten Drucktischs 8_2 in der Förderbahn 4 Substrate weiter zu dem in Förderrichtung weiter hinter liegenden Drucktisch 9_1 des zweiten Transportpendels 9. Dort wird das Substrat 20 entsprechend aufgenommen und beispielsweise der Druckeinrichtung 3 durch Absenken, Verdrehen und Anheben des Transportpendels 9 zugeführt. Es entsteht dadurch eine Druckvorrichtung mit sehr geringer Taktzeit beziehungsweise hohen Durchsatzraten. Flut- und Druckprozesse sowie Substrat-Zuführung und -Abführung können zeitlich zu einem maximalen Grad parallelisiert werden. Dabei können aus Kostengründen und je nach Prozessanforderungen Vorrichtungen, wie beispielsweise eine x, y, α-Siebpositionsverstellung 22 und/oder eine Rakelbewegungsachse 23 nur einmal vorhanden beziehungsweise ausgebildet sein.

Es zeigt sich dabei, dass den Druckeinrichtungen 2, 3 beispielsweise auch unterschiedliche Substrate zugeführt werden können. Aufgrund der vorteilhaften Anordnung wird erreicht, dass die Druckeinrichtungen 2, 3 nur jeweils jedes zweite Substrat aufnehmen. Sind in der Reihe der zugeführten Substrate beispielsweise Substrate 20 der Art A und B abwechselnd auf der Förderbahn 4 angeordnet, werden die Substrate 20 der Art A jeweils der Druckeinrichtung 2 durch das Transportpendel 8 und die Substrate 20 der Art B der Druckeinrichtung 3 durch das Transportpendel 9 zugeführt werden.

Im Unterschied zu dem dargestellten Ausführungsbeispiel ist es grundsätzlich auch denkbar, dass die Pendelachsen 10, 11 horizontal ausgerichtet sind, sodass die Drucktische 8_1, 9 2, 9_1, 9_2 auf einer Kreisbahn in einer vertikalen Ebene bewegt werden.

## Patentansprüche

1. Druckvorrichtung (1) zum Bedrucken von Substraten (20), insbesondere Solarzellen, Wafer, Leiterplatten oder dergleichen, mit zumindest einer Druckeinrichtung (2,3), der zumindest ein bewegbarer Drucktisch (8_1,8_2,9_1,9_2) zugeordnet ist, mit einer Förderbahn (4), entlang welcher die Substrate (20) bewegbar sind, und mit einer Transporteinrichtung zum Transportieren der Substrate von der Förderbahn (4) zu der zumindest einen Druckeinrichtung (2,3) und zurück, wobei die Transporteinrichtung zumindest ein um eine Pendelachse (10,11) verschwenkbares oder drehbares Transportpendel (8,9) aufweist, das an zumindest einem von der Pendelachse beabstandeten Ende den Drucktisch (8_1,8_2,9_1,9_2) aufweist, wobei der Drucktisch (8_1,8_2,9_1,9_2) durch das Transportpendel (8,9) in eine erste der Druckeinrichtung (2,3) zugeordnete Position für einen Druckvorgang und in eine zweite in der Förderbahn (4) liegende Position verschwenkbar ist, wobei der jeweilige Drucktisch (8_1,8_2,9_1,9_2) eine Fördereinrichtung (13) aufweist, welche die Förderbahn (4) in der zweiten Position des Drucktischs (8_1,8_2,9_1,9_2) mitbildet, **dadurch gekennzeichnet, dass** die Transporteinrichtung wenigstens ein weiteres Transportpendel (8,9) aufweist, das wie das eine Transportpendel (8,9) ausgebildet und neben dem einen Transportpendel (8,9) angeordnet ist, dass die Transportpendel (8,9) derart nah zueinander in einer Roots-Anordnung angeordnet sind, dass sich die Bewegungsbahnen der Drucktische (8_1,8_2,9_1,9_2) überschneiden, und dass die Transportpendel (8,9) mechanisch oder elektrisch miteinander gekoppelt sind, sodass ein Kollidieren der Drucktische (8_1,8_2,9_1,9_2) miteinander verhindert wird.

2. Druckvorrichtung nach Anspruch 1, **dadurch gekennzeichnet, dass** an zumindest zwei von der Pendelachse (10,11) beabstandeten Enden des Transportpendels (8,9) jeweils ein Drucktisch (8_1,8_2,9_1,9_2) angeordnet ist.

3. Druckvorrichtung nach einem der vorhergehenden Ansprüche, **dadurch gekennzeichnet, dass** die Drucktische (8_1,8_2,9_1,9_2) diametral einander gegenüberliegend zu der Pendelachse (10,11) angeordnet sind.

4. Druckvorrichtung nach einem der vorhergehenden Ansprüche, **dadurch gekennzeichnet, dass** die jeweilige Fördereinrichtung (13) ein antreibbares Förderband (14), insbesondere Vakuumband, Papierband oder dergleichen, aufweist, das eine Substratauflage (15) für das Substrat (20) auf der Oberseite des jeweiligen Drucktischs (8_1,8_2,9_1,9_2) bildet.

5. Druckvorrichtung nach einem der vorhergehenden Ansprüche, **dadurch gekennzeichnet, dass** die jeweilige Fördereinrichtung (13) eine austauschbare Förderbandkassette (17) aufweist.

6. Druckvorrichtung nach einem der vorhergehenden Ansprüche, **dadurch gekennzeichnet, dass** die Förderbahn (4) für jedes der Transportpendel (8,9) eine Unterbrechung (5,6) aufweist, die von jeweils einem Drucktisch (8_1,9_2) ausfüllbar oder ersetzbar ist, um die Förderbahn (4) zu vervollständigen.

7. Druckvorrichtung nach einem der vorhergehenden Ansprüche, **dadurch gekennzeichnet, dass** die Pendelachse (10,11) vertikal ausgerichtet ist, sodass der jeweilige Drucktisch (8_1,8_2,9_1,9_2) durch das Transportpendel (8,9) in einer horizontalen Ebene bewegbar ist.

8. Druckvorrichtung nach einem der vorhergehenden Ansprüche, **dadurch gekennzeichnet, dass** zumindest die Substratauflage (15) jedes Drucktischs (8_1,8_2,9_1,9_2) vertikal verschiebbar ist.

9. Druckvorrichtung nach einem der vorhergehenden Ansprüche, **dadurch gekennzeichnet, dass** an der ersten und/oder zweiten Position des jeweiligen Drucktischs (8_1,8_2,9_1,9_2) und/oder an jedem Drucktisch (8_1,8_2,9_1,9_2) eine Hebeeinrichtung (18,19) für die jeweilige Substratauflage (15) angeordnet ist.

10. Druckvorrichtung nach Anspruch 9 **dadurch gekennzeichnet, dass** die jeweilige Hebeeinrichtung (18,19) dazu ausgebildet ist, ein Substrat (20) von einer Transportposition in eine Druckposition an der Druckeinrichtung (2,3) und/oder in eine Förderposition an der Förderbahn (4) anzuheben.

11. Druckvorrichtung nach einem der vorhergehenden Ansprüche, **dadurch gekennzeichnet, dass** die Transportpendel (8,9) in ihrer ersten Position einer gemeinsamen Druckeinrichtung (2,3) oder jeweils einer eigenen Druckeinrichtung (2,3) zugeordnet sind.

12. Druckvorrichtung nach einem der vorhergehenden Ansprüche, **dadurch gekennzeichnet, dass** die jeweilige Pendelachse (10,11) horizontal ausgerichtet ist, sodass der jeweilige Drucktisch (8_1,8_2,9_1,9_2) durch das Transportpendel (8,9) in einer vertikalen Ebene bewegbar ist.

## Claims

1. Printing apparatus (1) for printing on substrates (20), in particular solar cells, wafers, printed circuit boards or the like, with at least one printing device (2, 3), which is assigned at least one movable printing table (8_1, 8_2, 9_1, 9 2), has a conveyor track (4), along which the substrates (20) are movable, and has a transport device for transporting the substrates from the conveyor track (4) to the at least one printing device (2, 3) and back, whereby the transport device has at least one transport pendulum (8, 9), which is pivotable or rotatable about a pivot axis (10, 11), and has the printing table (8_1, 8_2, 9_1, 9_2) at at least one end spaced from the pendulum axis, whereby the printing table (8_1, 8_2, 9_1, 9_2) is insertable by the transport pendulum (8, 9) into a first position of the printing device (2, 3) for a printing operation and pivotable into a second position in the conveyor track (4), whereby the respective printing table (8_1, 8_2, 9_1, 9_2) has a conveyor device (13) which forms the conveyor track (4) in the second position of the printing table (8_1, 8_2, 9_1, 9 2), **characterized in that** the transport device has at least one further transport pendulum (8, 9) which is formed like the one transport pendulum (8, 9) and is arranged next to the one transport pendulum (8, 9), that the transport pendulums (8, 9) are arranged close to one another in a roots-arrangement in such a way that the movement paths of the printing tables (8_1, 8_2, 9_1, 9 2) overlap, and that the transport pendulums (8,9) are mechanically or electrically coupled to each other, so that colliding of the printing tables (8_1,8_2,9_1,9_2) with each other is prevented.

2. Printing apparatus according to claim 1, **characterized in that** a respective printing table (8_1, 8 2, 9_1, 9 2) is arranged at least two ends of the transport pendulum (8, 9) spaced apart from the pendulum axis (10, 11).

3. Printing apparatus according to any one of the preceding claims, **characterized in that** the printing tables (8_1, 8_2, 9_1, 9_2) are arranged diametrically opposite each other to the pendulum axis (10, 11).

4. Printing apparatus according to any one of the preceding claims, **characterized in that** the respective conveying device (13) has a drivable conveyor belt (14), in particular a vacuum belt, paper belt or the like, which forms a substrate support (15) for the substrate (20) on the upper side of the respective printing table (8_1, 8_2, 9_1, 9 2).

5. Printing apparatus according to any one of the preceding claims, **characterized in that** the respective conveying device (13) has an exchangeable conveyor belt cartridge (17).

6. Printing apparatus according to any one of the preceding claims, **characterized in that** the conveyor track (4) has an interruption (5, 6) for each of the transport pendulums (8, 9), which can be filled or replaced by a respective printing table (8_1, 9 2) in order to complete the conveyor track (4).

7. Printing apparatus according to any one of the preceding claims, **characterized in that** the pendulum axis (10, 11) is vertically aligned, so that the respective printing table (8_1, 8 2, 9_1, 9 2) is movable by the transporting pendulum (8, 9) in a horizontal plane.

8. Printing apparatus according to any of the preceding claims, **characterized in that** at least the substrate support (15) of each printing table (8_1, 8_2,9_1, 9_2) is vertically displaceable.

9. Printing apparatus according to any one of the preceding claims, **characterized in that** at the first and/or second position of the respective printing table (8_1, 8 2, 9_1, 9_2) and/or at each printing table (8_1, 8 2, 9_1, 9 2) a lifting device (18, 19) for the respective substrate support (15) is arranged.

10. Printing apparatus according to claim 9, **characterized in that** the respective lifting device (18, 19) is designed to lift a substrate (20) from a transport position to a printing position on the printing device (2, 3) and/or into a conveying position on the conveyor track (4).

11. Printing apparatus according to any one of the preceding claims, **characterized in that** the transport pendulums (8, 9) are assigned in their first position to a common printing device (2, 3) or in each case to a separate printing device (2, 3).

12. Printing apparatus according to any one of the preceding claims, **characterized in that** the respective pendulum axis (10, 11) is oriented horizontally so that the respective printing table (8_1, 8_2, 9_1, 9 2) can be moved in a vertical plane by the transport pendulum (8, 9).

## Revendications

1. Appareil d'impression (1) pour l'impression des substrats (20), notamment des cellules solaires, wafers, cartes de circuits imprimés ou similaire, avec au moins un dispositif d'impression (2, 3) auquel est associée au moins une table d'impression mobile (8_1, 8 2, 9_1, 9 2) avec une voie de convoyage (4) le long de laquelle les substrats (20) peuvent être mûs, et avec un dispositif de transport pour transporter les substrats depuis la voie de convoyage (4) vers l'au moins un dispositif d'impression (2, 3) et retour à la voie, dans lequel le dispositif de transport comporte au moins un pendule de transport (8, 9) basculant ou tournable autour d'un axe de pendule (10, 11), le pendule comportant, au niveau d'au moins une extrémité espacée de l'axe de pendule, la table d'impression (8_1, 8_2, 9_1, 9_2), la table d'impression (8_1, 8_2, 9_1, 9_2) pouvant être basculée par le pendule de transport (8, 9) dans une première position associée au dispositif d'impression (2, 3) pour une opération d'impression, et dans une deuxième position située dans la voie de convoyage (4), la table d'impression respective (8_1, 8_2, 9_1, 9_2) comportant un dispositif de convoyage (13) partageant dans la formation de la voie de convoyage (4) dans la deuxième position de la table d'impression (8_1, 8_2, 9_1, 9_2), **caractérisé en ce que** le dispositif de transport comporte au moins un autre pendule de transport (8, 9) qui est configuré comme le pendule de transport (8, 9) et qui est disposé à côté du pendule de transport (8, 9), que les pendules de transport (8, 9) sont disposés l'un à proximité de l'autre dans un agencement Roots de telle manière que les trajectoires des tables d'impression (8_1, 8 2, 9_1, 9_2) se croisent, et que les pendules de transport (8, 9) sont couplés entre eux mécaniquement ou électriquement de telle manière qu'une collision des tables d'impression (8_1, 8_2, 9_1, 9_2) soit évitée.

2. Appareil d'impression selon la revendication 1, **caractérisé en ce que** respectivement une table d'impression (8_1, 8_2, 9_1, 9_2) est disposée au niveau d'au moins deux extrémités du pendule de transport (8, 9) espacées de l'axe de pendule (10, 11).

3. Appareil d'impression selon l'une quelconque des revendications précédentes, **caractérisé en ce que** les tables d'impression (8_1, 8_2, 9_1, 9 2) sont disposées diamétralement opposées entre elles par rapport à l'axe de pendule (10, 11).

4. Appareil d'impression selon l'une quelconque des revendications précédentes, **caractérisé en ce que** le dispositif de convoyage (13) respectif comporte un convoyeur à bande (14) entrainable, notamment à bande d'aspiration, à bande de papier ou similaire, qui forme un support de substrat (15) pour le substrat (20) sur la surface supérieure de la table d'impression (8_1, 8_2, 9_1, 9 2) respective.

5. Appareil d'impression selon l'une quelconque des revendications précédentes, **caractérisé en ce que** le dispositif de convoyage (13) respectif comporte une cassette de convoyeur à bande (17) échangeable.

6. Appareil d'impression selon l'une quelconque des revendications précédentes, **caractérisé en ce que** la voie de convoyage (4) pour chacun des pendules de transport (8, 9) comporte une interruption (5, 6) qui est remplissable ou remplaçable respectivement par une table d'impression (8_1, 9_2), afin de compléter la voie de convoyage (4).

7. Appareil d'impression selon l'une quelconque des revendications précédentes, **caractérisé en ce que** l'axe de pendule (10, 11) est aligné verticalement de telle manière que la table d'impression (8_1, 8_2, 9_1, 9 2) respective soit mobile par le pendule de transport (8, 9) dans un plan horizontal.

8. Appareil d'impression selon l'une quelconque des revendications précédentes, **caractérisé en ce qu'**au moins le support de substrat (15) de chaque table d'impression (8_1, 8_2, 9_1, 9_2) est déplaçable verticalement.

9. Appareil d'impression selon l'une quelconque des revendications précédentes, **caractérisé en ce qu'**un dispositif de levage (18, 19) pour le support de substrat (15) respectif est disposé au niveau de la première et/ou seconde position de la table d'impression (8_1, 8_2, 9_1, 9_2) respective et/ou sur chaque table d'impression (8_1, 8_2, 9_1, 9_2).

10. Appareil d'impression selon la revendication 9, **caractérisé en ce que** le dispositif de levage (18, 19) respectif est configuré pour lever un substrat (20) d'une position de transport dans une position d'impression sur le dispositif d'impression (2, 3) et/ou dans une position de convoyage sur la voie de convoyage (4).

11. Appareil d'impression selon l'une quelconque des revendications précédentes, **caractérisé en ce que** les pendules de transport (8, 9) sont associés, dans leur première position, à un dispositif d'impression (2, 3) commun, ou chacun à son propre dispositif d'impression (2, 3) respectif.

12. Appareil d'impression selon l'une quelconque des revendications précédentes, **caractérisé en ce que** l'axe de pendule (10, 11) respectif est aligné horizontalement de telle manière que la table d'impression (8_1, 8_2, 9_1, 9 2) respectif puisse être mûe par le pendule de transport (8, 9) dans un plan vertical.
